(19) Europäisches Patentamt
European Patent Office
Office européen des brevets

(11) EP 2 739 428 B1

(12) EUROPÄISCHE PATENTSCHRIFT

(45) Veröffentlichungstag und Bekanntmachung des Hinweises auf die Patenterteilung:
14.10.2015 Patentblatt 2015/42

(51) Int Cl.:
B23K 20/10 (2006.01)   B06B 1/06 (2006.01)

(21) Anmeldenummer: 12780077.9

(22) Anmeldetag: 26.07.2012

(86) Internationale Anmeldenummer:
PCT/DE2012/000753

(87) Internationale Veröffentlichungsnummer:
WO 2013/020539 (14.02.2013 Gazette 2013/07)

(54) **VERFAHREN UND VORRICHTUNG ZUM ULTRASCHALLBONDEN MIT MINDESTENS EINEM ERSTEN UND ZWEITEN HARMONISCHEN SCHWINGUNGSTEILE ERZEUGENDEN ULTRASCHALLTRANSDUCERN**

METHOD OF AND DEVICE FOR ULTRASONIC BONDING HAVING AT LEAST ONE FIRST AND SECOND ULTRASONIC TRANSDUCER GENERATING HARMONIC OSCILLATING PARTS

PROCÉDÉ ET DISPOSITIF D'ASSEMBLAGE PAR ULTRASONS AU MOYEN D'AU MOINS UN PREMIER ET UN DEUXIÈME TRANSDUCTEUR ULTRASONIQUE GÉNÉRANT DES PARTIES D'OSCILLATIONS HARMONIQUES

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 05.08.2011 DE 102011080534

(43) Veröffentlichungstag der Anmeldung:
11.06.2014 Patentblatt 2014/24

(73) Patentinhaber: Hesse GmbH
33100 Paderborn (DE)

(72) Erfinder:
• HESSE, Hans-Jürgen
33106 Paderborn (DE)
• BRÖKELMANN, Michael
33129 Delbrück (DE)

(74) Vertreter: Wickord, Wiro
Tarvenkorn & Wickord Patentanwälte
Partnerschaftsgesellschaft mbB
Technologiepark 11
33100 Paderborn (DE)

(56) Entgegenhaltungen:
EP-A1- 1 317 990    JP-A- 5 064 465
US-A- 5 578 888

**Beschreibung**

Die Erfindung betrifft ein Verfahren zum Ultraschallbonden gemäß dem Oberbegriff des Anspruchs 1.

Ferner betrifft die Erfindung eine Vorrichtung zur Durchführung des Bondverfahrens gemäß dem Oberbegriff des Anspruchs 12.

Aus dem nächstliegenden Stand der Technik EP 1 317 990 A1 ist ein sogenannter Ultraschall-Kreuztransducer mit wenigstens zwei einer gemeinsamen Wirkebene zugeordneten Ultraschalltransducern zum Erzeugen von zwei Ultraschall-Longitudinalwellen in einer parallel zu einem Substrat orientierten Wirkebene bekannt. Die in den Ultraschalltransducern erzeugten Ultraschallwellen werden durch die den Ultraschalltransducern zugeordneten, den Ultraschall leitenden Arme aus unterschiedlichen Raumrichtungen an eine Verbindungsstelle der Arme geleitet und dort direkt oder indirekt über ein Verbindungselement einem Ultraschallwerkzeug zugeführt. Das Ultraschallwerkzeug ragt bevorzugt senkrecht von der Wirkebene des Ultraschalltransducers ab in Richtung des Substrats. Das Werkzeug wird zu Biegeschwingungen angeregt. Infolge der Biegeschwingung führt eine dem Substrat zugewandte Werkzeugspitze eine Bewegung aus, die kontaktbehaftet auf ein mit dem Substrat zu verbindendes Bauelement, beispielsweise einen Halbleiterchip oder einen Bonddraht, übertragen wird. Durch die Relativbewegung zwischen Substrat und Bauelement wird durch Reibschweissen in der Kontaktfläche eine metallische Verbindung hergestellt. Durch die winkelversetzte Anordnung der Ultraschalltransducer zueinander - bevorzugt sind vier unter einem Winkel von jeweils 90° zueinander angeordnete Ultraschalltransducer vorgesehen - kann in der Wirkebene eine zweidimensionale Ultraschallschwingung erzeugt und auf das Bauelement übertragen werden. Während es bei eindimensionalen Ultraschallbondverfahren zu einer sich zeitlich ändernden Relativgeschwindigkeit und - beschleunigung zwischen Substrat und Bauelement kommt, und in jedem Umkehrpunkt der Bewegung ein Übergang von Haft- zu Gleitreibung stattfindet, kann bei der Verwendung des Ultraschall-Kreuztransducers eine betragsmäßig konstante Geschwindigkeit bzw. Beschleunigung zwischen Substrat und Bauelement erreicht und ein ständiger Wechsel zwischen Haft- und Gleitreibung vermieden werden. Hierdurch reduziert sich die mechanische Beanspruchung der mit dem Substrat zu verbindenden Bauelemente, wodurch das Verfahren zum Bonden von empfindlichen Halbleiterchips besonders geeignet ist. Aufgrund der nicht mehr vorhandenen Haft-Gleit-Übergänge steht bei gleicher elektrischer Eingangsleistung eine höhere mechanische Ausgangsleistung für die Durchführung des Schweißprozesses zur Verfügung. Dieselbe zur Verbindungsbildung benötigte Reibarbeit kann dann mit kleineren Amplituden in kürzerer Zeit geleistet werden. Dies ist besonders vorteilhaft, weil bei der Flip-Chip-Technologie infolge einer Zunahme der elektrischen Kontakte je Chip auch die insgesamt zu leistende Reibarbeit zunimmt und deshalb bei einer gleich bleibenden Zykluszeit die Schweißleistung vergrößert werden muss, um Chips mit einer hohen Zahl elektrischer Kontakte zu verschweißen. Die während eines Zyklus der harmonischen Schwingung des Systems an der Schweißstelle geleistete Arbeit ist proportional zum Radius des Kreises bzw. zu den Halbachsen der Ellipsen der sich einstellenden Bewegung, und diese sind begrenzt durch die maximal erreichbare Amplitude der Ultraschalltransducer.

Die US 5,578,888 A beschreibt einen Ultraschallgenerator für Ultraschalltransducer, der bei verschiedenen, jeweils fest vorgegebenen Frequenzen betrieben werden kann. Aus der JP 5 064465 A ist ein Ultraschall-Rotationsmotor bekannt, der nach dem Stößelprinzip arbeitet. Eine rotatorisch gelagerte und angetriebene Welle wird hierbei in einer kreuzartig angeordneten Antriebseinheit angetrieben, wobei jede Antriebseinheit nach dem Stößelprinzip ausgeführt ist und zwei Ultraschalltransducer aufweist zum Bereitstellen der Stößelbewegung.

Aufgabe der vorliegenden Erfindung ist es daher, ein Verfahren für das Ultraschallbonden derart weiterzubilden, dass die Schweißleistung bei konstanter

Bewegungsamplitude erhöht bzw. die Bewegungsamplitude bei konstanter Schweißleistung reduziert werden kann und Übergänge von Haft- zu Gleitreibung vermieden werden.

Zur Lösung der Aufgabe ist die Erfindung durch ein Verfahren und eine Vorrichtung gemäß Ansprüche 1 und 12 definiert.

Der besondere Vorteil der Erfindung besteht darin, dass bei konstanter Normalkraft und konstanter Amplitude der ersten Harmonischen durch Multiplikation der Amplitude mit einer höher Harmonischen bzw. durch Addition einer höheren Harmonischen mit einer kleinerer Amplitude in den Bondkontakt eine höhere Schweißleistung in den Bondkontakt eingebracht werden kann. Hierdurch ist es möglich, die Taktzeiten zu verkürzen bzw. bei gleichen Amplituden (d.h. bei etwa konstanter mechanischer Belastung der Chips) die Verbindungsenergie auch für größere Flächen verfügbar zu machen.

Beispielsweise kann ein einzelner Ultraschalltransducer vorgesehen sein, der eine multiharmonische bzw. mehrfrequente Anregung bereitstellt.

Beispielsweise kann vorgesehen sein, den ersten harmonischen Schwingungsanteil zweier um 90° räumlich versetzt zueinander angeordneter Ultraschalltransducer, welche mit 90° zeitlichem Phasenversatz angesteuert werden, zu nutzen, um durch ein phasenrichtiges Zusammenführen von Sinus- und Kosinusschwingungen eine Grundschwingung auszubilden, bei der die dem Substrat zugewandte Werkzeugspitze eine Bewegung ausführt, deren Trajektorie auf dem Substrat die Form eines Kreises, einer Ellipse oder einer beliebigen anderen Lissajous-Figur aufweist. Frequenz und Amplitude der ersten harmonischen Schwingungsanteile können beispielsweise denen heutiger Ultraschall-Transducer entsprechen. Zusätzlich zu dem ersten harmonischen Schwingungsanteil wird in einem oder beiden Transducem ein zweiter Schwingungsanteil überlagert. Durch die additive Überlagerung des zweiten Schwingungsanteils vergrößern sich bei ansonsten konstanten Verfahrensparametern je Zeiteinheit der von der Werkzeugspitze durchlaufene Weg und damit die in einem Zyklus geleistete Schweißarbeit, welche sich als Integral des Produktes aus der Reibkraft und der Bahngeschwindigkeit ergibt.

Nach einer bevorzugten Ausführungsform der Erfindung erzeugt der Ultraschalltransducer den zweiten Schwingungsanteil als einen zweiten harmonischen Schwingungsanteils ist. Vorteilhaft können resonante harmonische Schwingungen vergleichsweise einfach angeregt werden, so dass sich die Auslegung des Kreuztransducers vereinfacht.

Nach einer Weiterbildung der Erfindung erzeugt der wenigstens eine Ultraschalltransducer eine Ultraschallwelle mit einem im Vergleich zu dem ersten harmonischen Schwingungsanteil höherfrequenten zweiten Schwingungsanteil. Optional weist der erste harmonische Schwingungsanteil eine erste Schwingungsamplitude und der zweite Schwingungsanteil eine gegenüber der ersten Amplitude kleinere zweite Amplitude auf. Beispielsweise kann der zweite Schwingungsanteil eine um den Faktor 2 bis 100 höhere Frequenz aufweisen als der erste Schwingungsanteil. Bevorzugt weist der zweite Schwingungsanteil eine Frequenz auf, die größer ist als die Frequenz des ersten harmonischen Schwingungsanteils, während die Schwingungsamplitude des zweiten Schwingungsanteils kleiner ist als die Schwingungsamplitude des ersten harmonischen Schwingungsanteils. Vorteilhaft wird hierdurch die Möglichkeit geschaffen, den Weg, welche die Werkzeugspitze je Zeiteinheit zurücklegt, bei näherungsweise konstanter Amplitude der Hauptschwingung (erster Schwingungsanteil) signifikant zu erhöhen. Beispielsweise kann der Weg in etwa verdoppelt werden, indem die Frequenz des zweiten Schwingungsanteils 10mal größer ist als die Frequenz des ersten Schwingungsanteils und die Amplitude des zweiten Schwingungsanteils etwa um den Faktor 3 kleiner ist als die Amplitude des ersten Schwingungsanteils. Da die Periodendauer konstant bleibt, verdoppelt sich mit dem Weg auch die Schweißleistung.

Nach einer Weiterbildung der Erfindung werden ein erster Ultraschalltransducer durch eine Ultraschallwelle mit einem ersten harmonischen Schwingungsanteil und mit einem zweiten Schwingungsanteil - und wenigstens ein zweiter Ultraschalltransducer mit einer Ultraschallwelle mit einem ersten harmonischen Schwingungsanteil und mit einem zweiten Schwingungsanteil angeregt. Die Transducer können in der Ebene auf unterschiedliche Weise angeordnet sein. Typischerweise können benachbarte Ultraschalltransducer in der Wirkebene unter einem Winkel von 30° bis 150° zueinander angeordnet werden. Vorteilhaft vereinfacht sich die Ansteuerung der Ultraschalltransducer und die Anregung des Werkzeugs durch eine regelmäßige, insbesondere symmetrische Anordnung derselben. Der Ultraschall-Kreuztransducer kann dann in vergleichsweise einfacher Weise gesteuert bzw. geregelt werden. Überdies vereinfacht sich die Konstruktion des gesamten Bondautomaten, wenn der Transducer näherungsweise symmetrisch ausgebildet sein kann. In diesem Fall sind die Reaktionskräfte gut·beherrschbar bzw. gleichen sich zum Teil aus mit der Folge, dass die Lager kleiner ausgeführt und die bewegten Massen reduziert werden können.

Nach einer Weiterbildung der Erfindung sind der erste Ultraschalltransducer und der zweite Ultraschalltransducer zueinander unter einem 90°-Winkel angeordnet, wobei der zweite Schwingungsanteil der ersten Ultraschallwelle orthogonal zu dem zweiten Schwingungsanteil der zweiten Ultraschallwelle ausgebildet ist. Durch das Vorsehen zueinander orthogonaler zweiter Schwingungsanteile vereinfacht sich das Zusammenführen der Ultraschallwellen des ersten und zweiten Ultraschalltransducers in der Verbindungsstelle.

Nach einer Weiterbildung der Erfindung erzeugt der wenigstens eine Ultraschalltransducer wenigstens eine Ultraschallwelle mit einem dritten Schwingungsanteil. Der dritte Schwingungsanteil kann beispielsweise als ein harmonischer dritter Schwingungsanteil erzeugt werden mit einer im Vergleich zum zweiten Schwingungsanteil höheren Schwingsfrequenz. Vorteilhaft kann der Ultraschalltransducer beispielsweise durch eine multiplikative Überlagerung von zwei Schwingungsanregungen unterschiedlicher Frequenz angeregt werden. Dies ist insbesondere im Bereich der Signalgenerierung einfach zu realisieren. Der zweite Schwingungsanteil und der dritte Schwingungsanteil können gleiche Amplituden aufweisen.

Nach einer Weiterbildung der Erfindung wird der wenigstens eine Ultraschallschwinger zur Erzeugung der ersten harmonischen Schwingung zu Schwingungen in einer ersten Eigenschwingungsform und zur Erzeugung des zweiten Schwingungsanteils und/oder des dritten Schwingungsanteils zu Schwingungen in wenigstens einer weiteren Eigenschwingungsform höherer Ordnung angeregt. Vorteilhaft können die Eigenschwingungen des Ultraschalltransducers mit vergleichsweise geringer Energie reproduzierbar angeregt werden. Die Eigenschwingungen bilden sich stabil aus, so dass der Ultraschallprozess ein hohes Maß an Stabilität und Reproduzierbarkeit aufweist. Die dem ersten Schwingungsanteil zugeordnete Eigenschwingungsform muss nicht die kleinstmögliche Eigenschwingungsform des Ultraschalltransducers sein.

Weitere Vorteile der Erfindung ergeben sich aus den weiteren Unteransprüchen.

Die Erfindung wird nachfolgend anhand von Zeichnungen näher erläutert.

Es zeigen:

Figur 1    eine Draufsicht auf einen Ultraschall-Kreuztransducer,

Figur 2       eine Werkzeugtrajektorie bei Betrieb des Transducers gemäß Figur 1 mit einem Verfahren nach einer ersten Ausführungsform der Erfindung,

Figur 3       eine Werkzeugtrajektorie bei Betrieb des Transducers gemäß Figur 1 mit einem Verfahren nach einer zweiten Ausführungsform der Erfindung und

Figur 4       eine Werkzeugtrajektorie bei Betrieb des Transducers gemäß Figur 1 mit einem Verfahren nach einer dritten Ausführungsform der Erfindung.

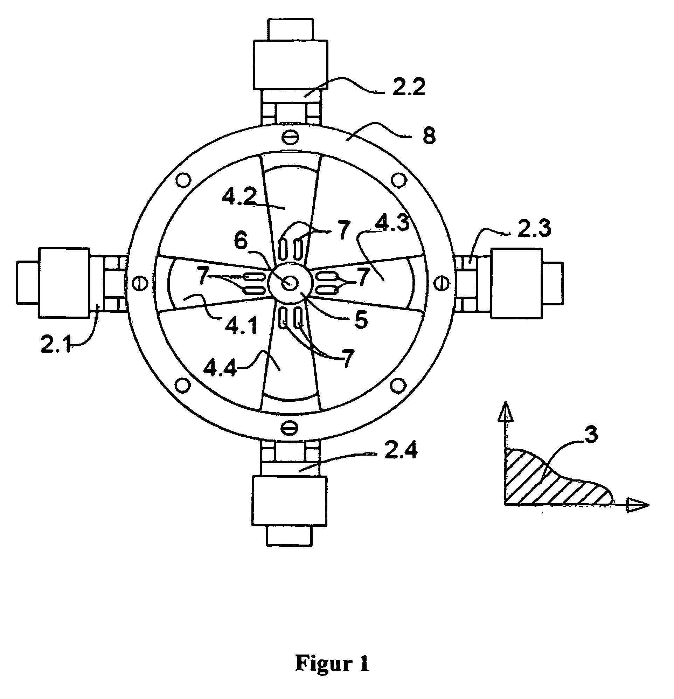

Ein Ultraschall-Kreuztransducer 1 nach Figur 1 weist als wesentliche Funktionskomponenten vier Ultraschalltransducer 2.1, 2.2, 2.3, 2.4 zum Erzeugen von Ultraschallwellen (Ultraschallschwingungen), den Ultraschalltransducern zugeordnete und in einer Wirkebene 3 des Ultraschall-Kreuztransducers 1 erstreckte Arme 4.1, 4.2, 4.3, 4.4, eine in einer Verbindungsstelle 6 der Arme 4.1, 4.2, 4.3, 4.4 vorgesehene Aufnahme 5 für ein nicht dargestelltes Ultraschallwerkzeug sowie einen die Ultraschalltransducer 2.1, 2.2, 2.3, 2.4, die Arme 4.1, 4.2, 4.3, 4.4 sowie die Aufnahme 5 tragenden Ring 8 auf. Jeweils zwei der vier Ultraschalltransducern 2.1, 2.2, 2.3, 2.4 sind einander paarweise unter einem Winkel von 180° zugeordnet. Der Ring 8 ist oberhalb der in der Wirkebene 3 angeordneten Ultraschalltransducer 2.1, 2.2, 2.3, 2.4 und Arme 4.1, 4.2, 4.3, 4.4 vorgesehen. Der Ring 8 erstreckt sich hierbei parallel zu der Wirkebene 3.

Die den Ultraschall leitenden Arme 4.1, 4.2, 4.3, 4.4 weisen im Bereich der Verbindungsstelle 6 in der Wirkebene 3 langlochartig ausgebildete Ausnehmungen 7 auf. Durch das Vorsehen der Ausnehmungen 7 wirken die der Verbindungsstelle 6 zugewandten Enden der Arme 4.1, 4.2, 4.3, 4.4 als Festkörpergelenke. Die Festkörpergelenke dienen der Lagerung der Aufnahme 5 und des Werkzeugs und der Entkopplung der orthogonal angeordneten Arme.

Zur Erzeugung der Ultraschallreibschweißschwingung werden die Ultraschalltransducer (2.1, 2.2, 2.3, 2.4) elektrisch derart angeregt, dass sich eine mechanische Longitudinalschwingung bildet, welche entlang der den Ultraschall leitenden Arme 4.1, 4.2, 4.3, 4.4 zu der die Aufnahme 5 bildenden Verbindungsstelle 6 geleitet, dort zusammengeführt und auf das nicht dargestellte, aus der Wirkebene 3 senkrecht in Richtung des Substrats abragende Ultraschallwerkzeug übertragen wird. Die Ultraschalltransducer 2.1, 2.2, 2.3, 2.4 weisen hierzu üblicherweise ein elektrisch zu Ultraschallschwingungen anregbares Piezoelement oder bevorzugt einen Piezoelementstapel auf. Erfindungsgemäß besteht die Ultraschallwelle aus einem ersten harmonischen und aus einem zweiten, beispielsweise auch harmonischen zweiten Schwingungsanteil. Die Transducer 2.1, 2.2, 2.3, 2.4 müssen in diesen Anregefrequenzen mindestens für die erste Anregefrequenz resonant schwingen und für die höhere Frequenz eine hinreichend kleine Impedanz aufweisen. In einer vorteilhaften Ausführungsform schwingt der Transducer 2.1, 2.2, 2.3, 2.4 für beide Anregefrequenzen resonant mit annähernd identischen Impedanzen.

Üblicherweise werden einander gegenüberliegende, das heißt um 180° gedreht zueinander angeordnete Ultraschalltransducer 2.1, 2.3 und 2.2, 2.4 derart zur Schwingung angeregt, dass der erste harmonische Schwingungsanteil der gegenüberliegenden Ultraschalltransducer um 180° phasenverschoben ausgebildet ist. Die ersten Schwingungsanteile einander um 90° versetzt zugeordnete Ultraschalltransducer 2.1, 2.2, 2.3, 2.4 weisen üblicherweise einen Phasenversatz von 90° auf. Beispielsweise wird ein erster Ultraschalltransducer 2.1 hinsichtlich des ersten harmonischen Schwingungsanteils zu einer Sinusschwingung, ein zweiter Ultraschalltransducer 2.3 exakt gegenphasig hierzu, d.h. um 180° phasenverschoben, ein dritter Ultraschalltransducer 2.2 zu einer Kosinusschwingung und ein vierter Ultraschalltransducer 2.4 exakt gegenphasig zu der Kosinusschwingung angeregt. Wenigstens ein Ultraschalltransducer 2.1, 2.2, 2.3. 2.4 weist zudem einen zweiten Schwingungsanteil, beispielsweise einen harmonischen zweiten Schwingungsanteil mit einer Schwingungsamplitude auf, die kleiner ist als die Schwingungsamplitude des ersten Schwingungsanteils desselben Ultraschalltransducers 2.1, 2.2, 2.3, 2.4.

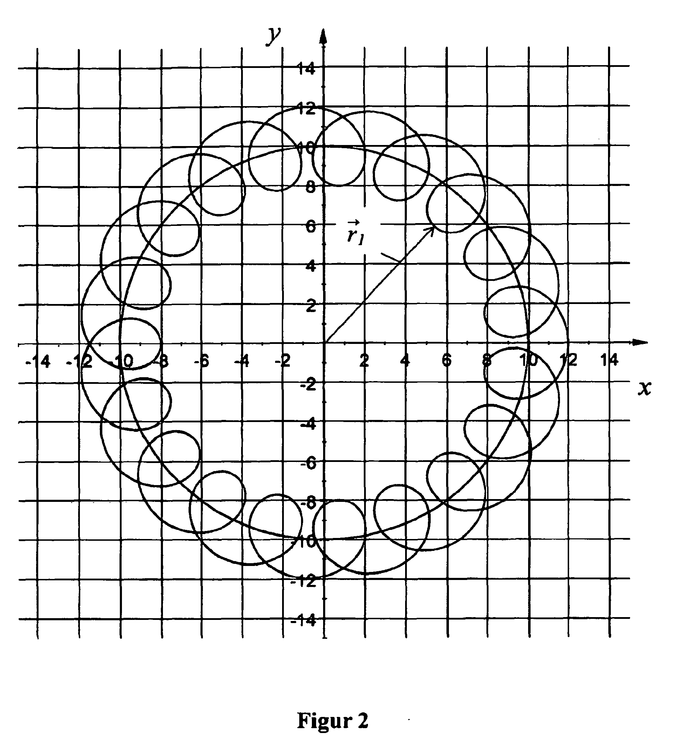

Die nachfolgenden Ausführungsbeispiele der Erfindung, welche anhand der Figuren 2 bis 4 näher erläutert werden, sehen einen Transducer mit zwei, bevorzugt mit vier im Winkelversatz von 90° zueinander angeordneten Ultraschalltransducern 2.1, 2.2, 2.3, 2.4 vor. Jeder Ultraschalltransducer 2.1, 2.2, 2.3, 2.4 erzeugt aufgrund seiner Ansteuerung eine Ultraschallwelle mit einem ersten harmonischen und mit einem zweiten harmonischen Schwingungsanteil. Die Ultraschallwellen der vier Ultraschalltransducer 2.1, 2.2, 2.3, 2.4 werden durch die zugeordneten Ultraschallarme 4.1, 4.2, 4.3, 4.4 zu der Verbindungsstelle 6 geleitet und dort zusammengeführt. Das in der Aufnahme 5 gehaltene, nicht dargestellte Werkzeug 6 wird infolge der Anregung durch die Ultraschallwellen Biegeschwingungen ausführen.

Zur Verdeutlichung der Anregung wird nachfolgend die zweidimensionale Bewegung eines dem Substrat zugewandten freien Endes des Werkzeugs visualisiert. Hierbei gibt die in den Graphen nach den Figuren 2 bis 4 dargestellte Graph die Bewegung der Werkzeugspitze (Werkzeugtrajektorie) wieder.

Gemäß der in Figur 2 dargestellten Werkzeugtrajektorie ist ein erster, niederfrequenter Schwingungsanteil mit großer Schwingungsamplitude A1 und ein zweiter Schwingungsanteil mit 25-facher Frequenz Ω2 und etwa 0,2-facher Amplitude A2 abgebildet. Die Werkzeugtrajektorie wird gebildet durch eine dem ersten Schwingungsanteil zugeordnete Kreisbahn und eine, dem zweiten Schwingungsanteil zugeordnete, überlagerte Schraubenbahn. Es ist deutlich erkennbar, dass die resultierende Werkzeugbewegung zu einer Wegstrecke führt, die signifikant größer ist als dies allein bei Anregung mit dem niederfrequenten Schwingungsanteil und der großen Schwingungsamplitude A1 der Fall ist. Da die größere Wegstrecke in gleicher Zeit durchlaufen wird, erhöht sich die Schweißleistung.

In dem dargestellten Koordinatensystem definiert sich die Ortskurve des Werkzeugs nach der Formel

$$\vec{r}_1(t) = \begin{pmatrix} x(t) \\ y(t) \end{pmatrix} = A_1 \begin{pmatrix} \cos(\Omega_1 t) \\ \sin(\Omega_1 t) \end{pmatrix} + A_2 \begin{pmatrix} \cos(\Omega_2 t) \\ \sin(\Omega_2 t) \end{pmatrix}$$

Hierbei entspricht A1 der Amplitude des ersten harmonischen Schwingungsanteils, A2 der Amplitude des zweiten harmonischen Schwingungsanteils, $\Omega 1$ der Frequenz des ersten harmonischen Schwingungsanteils und $\Omega 2$ der Frequenz des zweiten harmonischen Schwingungsanteils.

Die dargestellte Ortskurve ergibt sich durch additive Überlagerung der beiden Schwingungsanteile. Die x-Koordinate der Ortskurve ist von den zwei gegenüberliegenden, um 180° phasenversetzt angesteuerten Ultraschalltransducern 2.1, 2.3 angeregt, die y-Koordinaten von den beiden hierzu um 90° versetzt orientierten Ultraschalltransducern 2.2, 2.4.

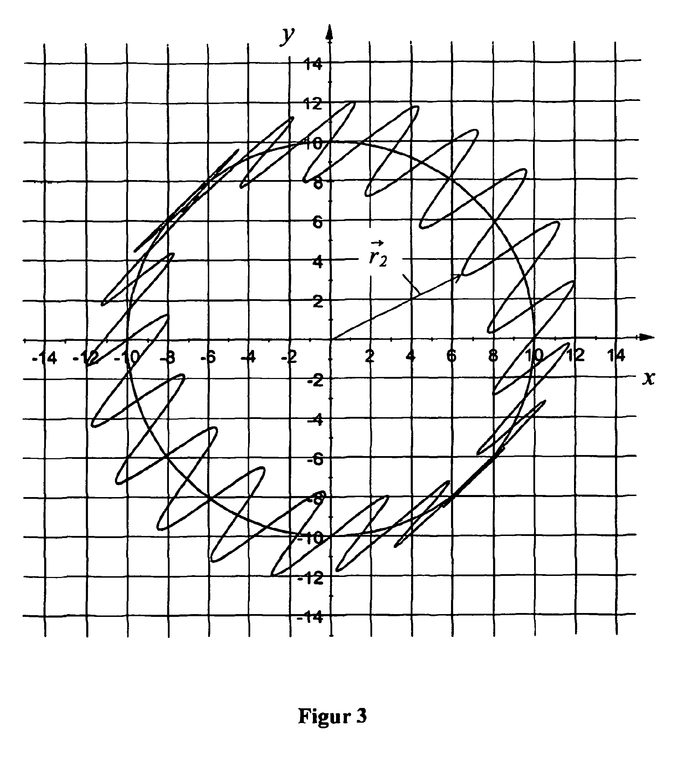

Figur 3 zeigt eine in ähnlicher Weise erzeugte Werkzeugtrajektorie, deren Ortskurve der Formel

$$\vec{r}_2(t) = \begin{pmatrix} x(t) \\ y(t) \end{pmatrix} = A_1 \begin{pmatrix} \cos(\Omega_1 t) \\ \sin(\Omega_1 t) \end{pmatrix} + A_2 \begin{pmatrix} \sin(\Omega_2 t) \\ \sin(\Omega_2 t) \end{pmatrix}$$

genügt und auf orthogonale Signale der zueinander senkrecht angeordneten Ultraschalltransducer 2.1, 2.2, 2.3, 2.4 im zweiten Schwingungsanteil verzichtet. Stattdessen werden die höheren Frequenzen in den benachbarten Ultraschalltransducer 2.1, 2.2, 2.3, 2.4 phasengleich angesteuert. Die entsprechende Ansteuerung kann vergleichsweise einfach realisiert werden, da auf eine entsprechende Phasenregelung der höheren Frequenzen verzichtet werden kann.

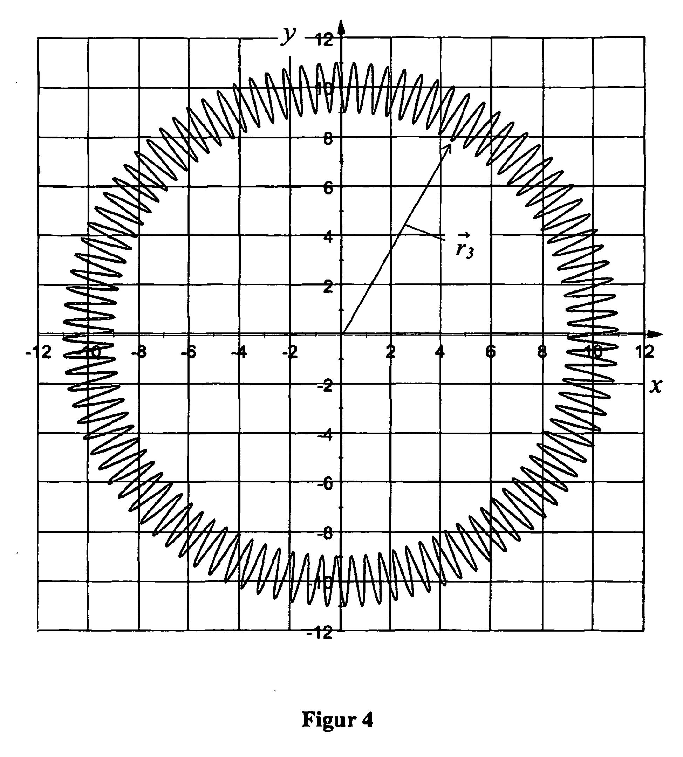

Gemäß Figur 4 wird die Ultraschallwelle nicht durch die Addition zweier Schwingungsanteile, sondern durch eine multiplikative Überlagerung der zwei Schwingungssignale gemäß der Formel

$$\vec{r}_3(t) = \begin{pmatrix} x(t) \\ y(t) \end{pmatrix} = \begin{pmatrix} (A_1 + A_2 \sin(\Omega_2 t)) \cdot \cos(\Omega_1 t) \\ (A_1 + A_2 \sin(\Omega_2 t)) \cdot \sin(\Omega_1 t) \end{pmatrix}$$

gebildet. Durch Ausmultiplizieren erhält die Ortskurve die folgende Form:

$$\vec{r}_3(t) = \begin{pmatrix} x(t) \\ y(t) \end{pmatrix} = \begin{pmatrix} (A_1 \cos(\Omega_1 t) + \dfrac{A_2}{2}[\sin((\Omega_2 - \Omega_1)t) + \sin((\Omega_2 + \Omega_1)t)] \\ (A_1 \sin(\Omega_1 t) + \dfrac{A_2}{2}[\cos((\Omega_2 - \Omega_1)t) - \cos((\Omega_2 + \Omega_1)t)] \end{pmatrix}$$

Es zeigt sich, dass die Ultraschallwelle einen ersten Schwingungsanteil, einen zweiten Schwingungsanteil und einen dritten Schwingungsanteil aufweist. Die drei Schwingungsanteile sind jeweils harmonisch ausgebildet, wobei der erste Schwingungsanteil eine große Amplitude A1 und eine kleine Frequenz $\Omega 1$ aufweist.

Der zweite und der dritte Schwingungsanteil besitzen die gleiche Amplitude A2. Jedoch unterscheiden sie sich hinsichtlich der Frequenz. Der zweite Schwingungsanteil besitzt die Frequenz $\Omega 2 - \Omega 1$, der dritte Schwingungsanteil die Frequenz $\Omega 2 + \Omega 1$. Hierbei ist in der graphischen Darstellung der Figur 4 $\Omega 2$ etwa um den Faktor 100 größer gewählt als $\Omega 1$ mit der Folge, dass die Frequenzen $\Omega 2 - \Omega 1$, $\Omega 2 + \Omega 1$, der zweiten und dritten Schwingungsanteile sehr nahe beieinander liegen.

Nach einer nicht dargestellten alternativen Ausführungsform der Erfindung können drei Ultraschalltransducer 2.1, 2.2, 2.3 in der gemeinsamen Wirkebene 3 räumlich um 120° versetzt angeordnet werden. Die drei Ultraschalltransducer 2.1, 2.2, 2.3 werden analog dem bekannten Vorgehen um 120° zeitlich phasenversetzt angesteuert zur Erzeugung des ersten Schwingungsanteils. Wenigstens einer der drei Ultraschalltransducer 2.1, 2.2, 2.3 erzeugt den zweiten Schwingungsanteil. Dieser zweite Schwingungsanteil kann vorzugsweise harmonisch und/oder - im Vergleich zum ersten Schwingungsanteil - höher frequent ausgebildet sein.

**Patentansprüche**

1. Verfahren zum Ultraschallbonden, wobei in einem oder mehreren Ultraschalltransducern (2.1, 2.2, 2.3, 2.4) zwei longitudinale, sich in einer gemeinsamen, parallel zu einem Substrat orientierten Wirkebene ausbreitende Ultraschallwelle angeregt werden, die durch Ultraschall leitende Arme (4.1, 4.2, 4.3, 4.4) aus verschiedenen Raumrichtungen auf eine gemeinsame Verbindungsstelle der Arme (4.1, 4.2, 4.3, 4.4) geleitet werden und an der Verbindungsstelle ein an dieser direkt oder indirekt angeordnetes Ultraschallwerkzeug in zwei- oder dreidimensionale Schwingungen versetzen, **dadurch gekennzeichnet, dass** wenigstens ein Ultraschalltransducer (2.1, 2.2, 2.3, 2.4) eine longitudinale Ultraschallwelle mit einem ersten harmonischen Schwingungsanteil und mit einem zweiten Schwingungsanteil anregt.

2. Verfahren nach Anspruch 1, **dadurch gekennzeichnet, dass** der wenigstens eine Ultraschalltransduer (2.1, 2.2, 2.3, 2.4) den zweiten Schwingungsanteil als einen zweiten harmonischen Schwingungsanteil anregt.

3. Verfahren nach Anspruch 1 oder 2, **dadurch gekennzeichnet, dass** der wenigstens eine Ultraschalltransducer (2.1, 2.2, 2.3, 2.4) die Ultraschallwelle mit einem im Vergleich zu dem ersten harmonischen Schwingungsanteil höherfre¬quenten zweiten Schwingungsanteil anregt.

4. Verfahren nach einem der Ansprüche 1 bis 3, **dadurch gekennzeichnet, dass** der wenigstens eine Ultraschalltransducer (2.1, 2.2, 2.3, 2.4) den ersten harmonischen Schwingungsanteil mit einer ersten Schwingungsamplitude und den zweiten Schwingungsanteil mit einer gegenüber der ersten Schwingungsamplitude kleineren zweiten Schwingungsamplitude anregt.

5. Verfahren nach einem der Ansprüche 1 bis 4, **dadurch gekennzeichnet, dass** wenigstens ein erster Ultraschalltransduer (2.1, 2.2, 2.3, 2.4) eine erste Ultraschallwelle mit einem ersten harmonischen Schwingungsanteil und mit einem zweiten Schwingungsanteil und wenigstens ein zweiter Ultraschalltransducer (2.1, 2.2, 2.3, 2.4) eine zweite Ultraschallwelle mit wenigstens einem ersten harmonischen Schwingungsanteil und mit einem zweiten harmonischen Schwingungsanteil anregt, wobei benachbarten Ultraschalltransducern (2.1, 2.2, 2.3, 2.4) zugeordnete Arme (4.1, 4.2, 4.3. 4.4) in der Wirkebene (3) unter einem Winkel von 30° bis 150° zueinander angeordnet sind.

6. Verfahren nach einem der Ansprüche 1 bis 5, **dadurch gekennzeichnet, dass** der erste Ultraschalltransducer (2.1, 2.3) und der zweite Ultraschalltransducer (2.2, 2.4) jeweils eine Ultraschallwelle erzeugen, wobei der dem ersten Ultraschalltransducer (2.1, 2.3) zugeordnete Arm (4.1, 4.3) und der dem zweiten Ultraschalltransducer (2.2, 2.4) zugeordnete Arm (4.2, 4.4) zueinander unter einem Winkel von 90° angeordnet sind und wobei der zweite Schwingungsanteil der ersten Ultraschallwelle orthogonal zu dem zweiten Schwingungsanteil der zweiten Ultraschallwelle ausgebildet ist.

7. Verfahren nach einem der Ansprüche 1 bis 6, **dadurch gekennzeichnet, dass** der wenigstens eine Ultraschalltransducer (2.1, 2.2, 2.3, 2.4) die Ultraschallwelle mit einem dritten Schwingungsanteil anregt.

8. Verfahren nach Anspruch 7, **dadurch gekennzeichnet, dass** der wenigstens eine Ultraschalltransducer (2.1, 2.2, 2.3, 2.4) den dritten Schwingungsanteil als einen dritten harmonischen Schwingungsanteil anregt.

9. Verfahren nach Anspruch 7 oder 8, **dadurch gekennzeichnet, dass** der wenigstens eine Ultraschalltransducer (2.1, 2.2, 2.3, 2.4) die Ultraschallwelle mit einem im Vergleich zu dem zweiten harmonischen Schwingungsanteil höherfrequenten dritten harmonischen Schwingungsanteil anregt.

10. Verfahren nach einem der Ansprüche 7 bis 9, **dadurch gekennzeichnet, dass** der wenigstens eine Ultraschalltransducer (2.1, 2.2, 2.3, 2.4) den zweiten Schwingungsanteil und den dritten Schwingungsanteil mit einer gleichen Schwingungsamplitude anregt.

11. Verfahren nach einem der Ansprüche 1 bis 10, **dadurch gekennzeichnet, dass** der Ultraschalltransducer (2.1, 2.2, 2.3, 2.4) zur Erzeugung des ersten harmonischen Schwingungsanteil der Ultraschallwelle zu Schwingungen in einer ersten Eigenschwingungsform und zur Erzeugung des zweiten Schwingungsanteils und/oder des dritten Schwingungsanteils der Ultraschallwelle zu Schwingungen in wenigstens einer weiteren Eigenschwingungsform höherer Ordnung angeordnet wird.

12. Vorrichtung zur Durchführung eines Verfahrens zum Ultraschallbonden nach einem der Ansprüche 1 bis 11 umfassend mehrere Ultraschalltransducer (2.1, 2.2, 2.3, 2.4) mit jeweils einem leitenden Arm (4.1, 4.2, 4.3, 4.), wobei mittels mindestens zweier Ultraschalltransducer (2.1, 2.2, 2.3, 2.4) mindestens zwei in einer gemeinsamen, parallel zu einem Substrat orientierten Wirkebene sich ausbreitende longitudinale Ultraschallwellen anregbar sind, **dadurch gekennzeichnet, dass** mittels mindestens eines Ultraschalltransducers (2.1, 2.2, 2.3, 2.4) eine longitudinale Ultraschallwelle mit einem ersten harmonischen Schwingungsanteil und mit einem zweiten Schwingungsanteil anregbar ist.

## Claims

1. Method for ultrasonic bonding, wherein two longitudinal ultrasonic waves propagating in a common working plane oriented in parallel with a substrate are induced in one or a plurality of ultrasonic transducers (2.1, 2.2, 2.3, 2.4) and are directed through ultrasound-conducting arms (4.1, 4.2, 4.3, 4.4) from different spatial directions onto a common connection point of the arms (4.1, 4.2, 4.3, 4.4), and at the connection point cause an ultrasonic tool arranged directly or indirectly at said connection point to oscillate in two or three dimensions, **characterised in that** at least one ultrasonic transducer (2.1, 2.2, 2.3, 2.4) induces a longitudinal ultrasonic wave with a first harmonic oscillation component and a second oscillation component.

2. Method as claimed in claim 1, **characterised in that** the at least one ultrasonic transducer (2.1, 2.2, 2.3, 2.4) induces the second oscillation component as a second harmonic oscillation component.

3. Method as claimed in claim 1 or 2, **characterised in that** the at least one ultrasonic transducer (2.1, 2.2, 2.3, 2.4) induces the ultrasonic wave with a second oscillation component which has a higher-frequency compared to the first harmonic oscillation component.

4. Method as claimed in any one of claims 1 to 3, **characterised in that** the at least one ultrasonic transducer (2.1, 2.2, 2.3, 2.4) induces the first harmonic oscillation component with a first oscillation amplitude and the second oscillation component with a second oscillation amplitude which is smaller compared to the first oscillation amplitude.

5. Method as claimed in any one of claims 1 to 4, **characterised in that** at least one first ultrasonic transducer (2.1, 2.2, 2.3, 2.4) induces a first ultrasonic wave with a first harmonic oscillation component and with a second oscillation component and at least one second ultrasonic transducer (2.1, 2.2, 2.3, 2.4) induces a second ultrasonic wave with at least one first harmonic oscillation component and with a second harmonic oscillation component, wherein arms (4.1, 4.2, 4.3, 4.4) associated with adjacent ultrasonic transducers (2.1, 2.2, 2.3, 2.4) are arranged in the working plane (3) at an angle of 30° to 150° with respect to one another.

6. Method as claimed in any one of claims 1 to 5, **characterised in that** the first ultrasonic transducer (2.1, 2.3) and the second ultrasonic transducer (2.2, 2.4) each generate an ultrasonic wave, wherein the arm (4.1, 4.3) associated with the first ultrasonic transducer (2.1, 2.3) and the arm (4.2, 4.4) associated with the second ultrasonic transducer (2.2, 2.4) are arranged at an angle of 90° with respect to one another and wherein the second oscillation component of the first ultrasonic wave is formed orthogonal to the second oscillation component of the second ultrasonic wave.

7. Method as claimed in any one of claims 1 to 6, **characterised in that** the at least one ultrasonic transducer (2.1, 2.2, 2.3, 2.4) induces the ultrasonic wave with a third oscillation component.

8. Method as claimed in claim 7, **characterised in that** the at least one ultrasonic transducer (2.1, 2.2, 2.3, 2.4) induces the third oscillation component as a third harmonic oscillation component.

9. Method as claimed in claim 7 or 8, **characterised in that** the at least one ultrasonic transducer (2.1, 2.2, 2.3, 2.4) induces the ultrasonic wave with a third harmonic oscillation component which has a higher-frequency compared to the second harmonic oscillation component.

**10.** Method as claimed in any one of claims 7 or 9, **characterised in that** the at least one ultrasonic transducer (2.1, 2.2, 2.3, 2.4) induces the second oscillation component and the third oscillation component with an equal oscillation amplitude.

**11.** Method as claimed in any one of claims 1 to 10, **characterised in that** the ultrasonic transducer (2.1, 2.2, 2.3, 2.4) is arranged to generate the first harmonic oscillation component of the ultrasonic wave to oscillations in a first self-oscillation form and to generate the second oscillation component and/or the third oscillation component of the ultrasonic wave to oscillations in at least one further self-oscillation form of a higher order.

**12.** Device for performing a method for ultrasonic bonding as claimed in any one of claims 1 to 11, comprising a plurality of ultrasonic transducers (21.1, 2.2, 2.3, 2.4) each having a conductive arm (4.1, 4.2, 4.3, 4.), wherein at least two longitudinal ultrasonic waves propagating in a common working plane oriented in parallel with a substrate can be induced by means of at least two ultrasonic transducers (2.1, 2.2, 2.3, 2.4), **characterised in that** a longitudinal ultrasonic wave with a first harmonic oscillation component and with a second oscillation component can be induced by means of at least one ultrasonic transducer (2.1, 2.2, 2.3, 2.4).

**Revendications**

**1.** Procédé d'assemblage par ultrasons, dans lequel deux ondes ultrasonores longitudinales, qui se propagent dans un plan actif commun orienté parallèlement à un substrat, sont excitées dans un ou plusieurs transducteurs ultrasoniques (2.1, 2.2, 2.3, 2.4) qui sont dirigées par des bras (4.1, 4.2, 4.3, 4.4) guidant des ultrasons à partir de différentes directions spatiales sur un point de connexion commun des bras (4.1, 4.2, 4.3, 4.4) et mettent alors en oscillations bidimensionnelles ou tridimensionnelles en ce point un outil à ultrasons disposé directement ou indirectement, **caractérisé par le fait qu'**au moins un transducteur ultrasonique (2.1, 2.2, 2.3, 2.4) excite une onde ultrasonore longitudinale présentant une première partie d'oscillation harmonique et une seconde partie d'oscillation.

**2.** Procédé selon la revendication 1, **caractérisé par le fait que** l'au moins un transducteur ultrasonique (2.1, 2.2, 2.3, 2.4) excite la seconde partie d'oscillation en tant que seconde partie d'oscillation harmonique.

**3.** Procédé selon la revendication 1 ou 2, **caractérisé par le fait que** l'au moins un transducteur ultrasonique (2.1, 2.2, 2.3, 2.4) excite l'onde ultrasonore présentant une seconde partie d'oscillation de haute fréquence par rapport à la première partie d'oscillation harmonique.

**4.** Procédé selon l'une des revendication 1 à 3, **caractérisé par le fait que** l'au moins un transducteur ultrasonique (2.1, 2.2, 2.3, 2.4) excite la première partie d'oscillation harmonique présentant une première amplitude d'oscillation et la seconde partie d'oscillation présentant une seconde amplitude d'oscillation plus faible par rapport à la première amplitude d'oscillation.

**5.** Procédé selon l'une des revendications 1 à 4, **caractérisé par le fait qu'**au moins un premier transducteur ultrasonique (2.1, 2.2, 2.3, 2.4) excite une première onde ultrasonore présentant une première partie d'oscillation harmonique et une seconde partie d'oscillation et au moins un second transducteur (2.1, 2.2, 2.3, 2.4) excite une seconde onde ultrasonore présentant au moins une première partie d'oscillation harmonique et une seconde partie d'oscillation harmonique, des bras (4.1, 4.2, 4.3, 4.4) associés à des transducteurs ultrasoniques (2.1, 2.2, 2.3, 2.4) voisins étant disposés les uns par rapport aux autres dans le plan actif (3) à un angle de 30° à 150°.

**6.** Procédé selon l'une des revendications 1 à 5, **caractérisé par le fait que** le premier transducteur ultrasonique (2.1, 2.3) et le second transducteur ultrasonique (2.2, 2.4) génèrent respectivement une onde ultrasonore, le bras (4.1, 4.3) associé au premier transducteur ultrasonique (2.1, 2.3) et le bras (4.2, 4.4) associé au second transducteur ultrasonique (2.2, 2.4) étant disposés entre eux à un angle de 90° et la seconde partie d'oscillation de la première onde ultrasonore étant réalisée orthogonale à la seconde partie d'oscillation de la seconde onde ultrasonore.

**7.** Procédé selon l'une des revendications 1 à 6, **caractérisé par le fait que** l'au moins un transducteur ultrasonique (2.1, 2.2, 2.3, 2.4) excite l'onde ultrasonore présentant une troisième partie d'oscillation.

**8.** Procédé selon la revendication 7, **caractérisé par le fait que** l'au moins un transducteur ultrasonique (2.1, 2.2, 2.3, 2.4) excite la troisième partie d'oscillation en tant que troisième partie d'oscillation harmonique.

**9.** Procédé selon la revendication 7 ou 8, **caractérisé par le fait que** l'au moins un transducteur ultrasonique (2.1, 2.2, 2.3, 2.4) excite l'onde ultrasonore présentant une troisième partie d'oscillation harmonique de haute fréquence par rapport à la seconde partie d'oscillation harmonique.

**10.** Procédé selon l'une des revendication 7 à 9, **caractérisé par le fait que** l'au moins un transducteur ultrasonique (2.1, 2.2, 2.3, 2.4) excite la seconde partie d'oscillation et la troisième partie d'oscillation avec une même amplitude d'oscillation.

**11.** Procédé selon l'une des revendication 1 à 10, **caractérisé par le fait que** le transducteur ultrasonique (2.1, 2.2, 2.3, 2.4) destiné à générer la première partie d'oscillation harmonique de l'onde ultrasonore est exposé pour être mis en oscillation dans une première forme d'oscillation propre et destiné à générer la seconde partie d'oscillation et/ou de la troisième partie d'oscillation est exposé pour être mis en oscillation dans au moins une autre forme d'oscillation propre d'ordre plus élevé.

**12.** Dispositif destiné à la réalisation d'un procédé d'assemblage par ultrasons selon l'une des revendications 1 à 11, comprenant plusieurs transducteurs ultrasoniques (2.1, 2.2, 2 ,3, 2.4) présentant chacun un bras de guidage (4.1, 4.2, 4.3, 4.), dans lequel au moins deux ondes ultrasonores longitudinales, qui se propagent dans un plan actif commun orienté parallèlement à un substrat, peuvent être excitées au moyen d'au moins deux transducteurs ultrasoniques (2.1, 2.2, 2.3, 2.4), **caractérisé par le fait qu'**une onde ultrasonore longitudinale présentant une première partie d'oscillation harmonique et une seconde partie d'oscillation peut être excitée au moyen d'au moins un transducteur ultrasonique (2.1, 2.2, 2.3, 2.4).

**Figur 1**

**Figur 2**

**Figur 3**

**Figur 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1317990 A1
- US 5578888 A
- JP 5064465 A